# EUROPEAN PATENT APPLICATION

(11) **EP 1 640 431 A1**
(43) Date of publication of application: **29.03.2006**
(21) Application number: 04733138.4
(22) Date of filing: 14.05.2004
(51) Int. Cl.: C09K 11/64, C09K 11/08, H01S 3/16

(54) **TRANSITION METAL DOPED SPINEL TYPE MGAL SB 2 /SB O SB 4 /SB PHOSPHOR, LASER APPARATUS INCLUDING THE SAME AND PROCESS FOR PRODUCING THE PHOSPHOR**

(30) Priority: 14.05.2003 JP 2003136537
(71) Applicant: Japan Science and Technology Corporation, Kawaguchi-shi, Saitama 332-0012 (JP)
(72) Inventor: HANAMURA, Eiichi, Chitose-shi, Hokkaido 0660061 (JP); KATO, Kiyoshi, Hokkaido 0611121 (JP); TERASHIMA, Takahito, Osaka 5810802 (JP); TAKANO, Mikio, Kyoto-shi, Kyoto 6168063 (JP); MURAOKA, Toshiharu, Kasai-gun, Hokkaido 0891332 (JP); YAMANAKA, Akio, Sapporo-shi, Hokkaido 0630034 (JP); KAWABE, Yutaka, Hokkaido 0660075 (JP); SATO, Tokushi, Tokyo 1450065 (JP); TOMITA, Ayana, Tokyo 1450062 (JP)
(74) Representative: Marshall, John Grahame
(86) International application number: PCT/JP2004/006852
(87) International publication number: WO 2004/101711

(57) **Abstract**

A transition metal doped spinel type MgAl₂O₄ fluorescent material capable of laser oscillation and a laser apparatus using the same. It is made from a mixed raw material of an Al raw material and a Mg raw material added thereto in an amount together with a transition metal raw material so that the amount of Mg exceeds that of Al by a few percents in terms of molar ratio, by shaping the mixed raw material under pressure to form a source material rod, and single-crystallizing the source material rod in a selected gaseous atmosphere by floating zone melting. The doping amount of Ti is such that in composition formula MgAl₂₋ₓ TiₓO₄ it lies in a range: 0.003 ≦ x ≦ 0.01. The doping amount of Mn is such that in composition formula Mg₁₋ₓMnₓAlO₄ it lies in a range: 0.003≦ x≦ 0.01.

## Description

### Technical Field

The present invention relates to a transition metal doped spinel type MgAl₂O₄ fluorescent material, i. e., a fluorescent material having a crystalline matrix made of MgAl₂O₄ single crystal with a spinel crystallographic structure and doped with a transition metal. It also relates to a transition metal doped MgAl₂O₄ laser apparatus, i. e., a laser apparatus using such a fluorescent material. The invention further relates to a method of making a transition metal-doped MgAl₂O₄ fluorescent material.

### Background Art

Fluorescent materials are known to be indispensable to a variety of color displays. Among them, there are also some classes of fluorescent materials doped with emission centers in an insulator crystalline matrix. Because of a broad emission spectrum, such a fluorescent material when used as a laser medium for a laser apparatus of external resonator type, is capable of laser oscillations over various wavelengths and when used as a laser medium for a source of an ultrashort light pulse, it is possible to make its time width extremely short. And, because of the facts that its fluorescent emission efficiency is high and that the higher of melting point, its matrix crystal the higher is the output of a laser using it, active researches on fluorescent materials of this type whose melting point of matrix crystals are high, have been conducted.

For example, while a ruby laser and a Ti-doped sapphire laser, both of which have a corundum type crystallographic structure, are widely utilized as excellent lasers, their laser medium is a fluorescent material of which the matrix crystal is of Al₂O₃ and the emission centers are of a transition metal. Excellent properties of these lasers owe much to the high melting point of their matrix crystal (i. e., a melting point of 2050 °C) as well as to its high crystal perfection which allows it to form an energy level that is high in terms of emission efficiency and optimum for laser oscillations when doped with a transition metal. Thus, if a fluorescent material can be made having a MgAl₂O₄ matrix crystal of spinel type crystallographic structure that has a melting point (i. e., 2135 °C) higher than that of the Al₂O₃ crystal and that is yet excellent in crystal perfection, it would make it possible to provide a laser that is yet higher in output.

However, although a fluorescent material having a MgAl₂O₄ matrix crystal with a spinel type crystallographic structure has been studied and expected as a fluorescent material that excels ruby and Ti-doped sapphire lasers, no such fluorescent material capable of laser oscillation has up to date been successfully obtained.

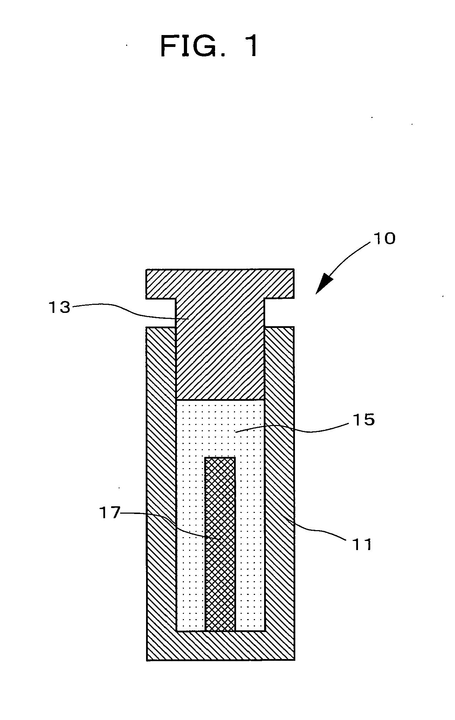

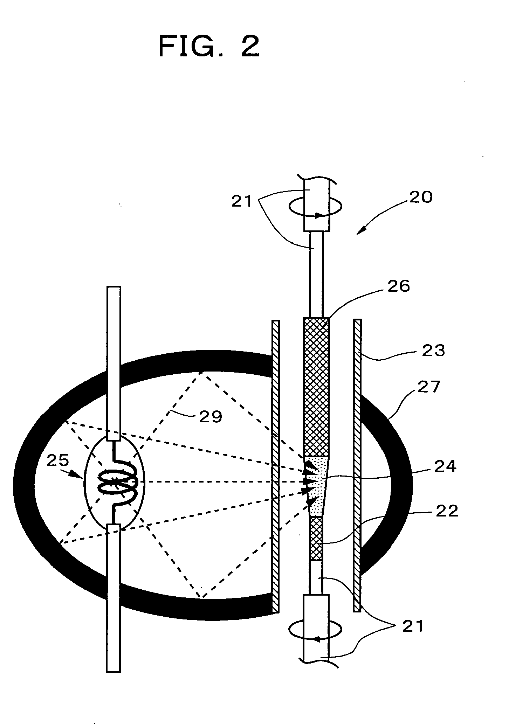

Document 1 (L. E. Bausa, I. Vergara and J. Garcia-sole: J. Appl. Phys. 68 (2), 15 July 1990, p. 736) describes a Ti doped spinel type MgAl₂O₄ fluorescent material having Ti doped at 0.05 atomic %, made by the Verneuil method. As seen from Fig. 1 in Document 1, the fluorescent material has absorption peaks at 490 nm and 790 nm, besides band edge absorption. Also, as shown in Fig. 2 of the Document, the fluorescent material has an emission peak of 465 nm by band edge excitation (266 nm) and an emission peak of 805 nm by excitation at 532 nm. Further, the 490 nm absorption, the 465 nm emission and the 805 emission of the fluorescent material are according to d - d transitions of d - electrons of Ti³⁺ located at B site of the spinel crystal in ligand field of 6 oxygens. Also, the 790 nm absorption is regarded as by Ti⁴⁺ - Fe²⁺ pair. Thus, the absorptions and emissions of this fluorescent material are mainly caused by d - d transitions most of which are electric dipole forbidden transitions and its emission efficiency must therefore be low. Further, there are absorptions by impurities observed, too, so the laser oscillation with this crystal is thought to be impossible. While the document states that using the 805 nm emission peak will make its infrared laser oscillation possible, this has not been confirmed.

Document 2 (R. Clausen and K. Peterman: IEEE Journal Q.E. E. 24 (1988) 1114) and Document 3 (K. Peterman et al., Opt. Commun. 70 (1989) 483) describe Mn doped spinel type MgAl₂O₄ fluorescent materials having Mn doped by 1 atomic % and 18 atomic %, made by the Czochralski and Verneuil methods. As seen from Fig. 1 in Document 3, these fluorescent materials have many absorption peaks over a wavelength range from 250 nm to 550 nm. These absorption peaks are according to d - d transitions of d - electrons of Mn²⁺ located at A site of the spinel crystal in ligand filed of 4 oxygens. Since most of d - d transitions are electric dipole forbidden transitions, its emission efficiency is considered to be low and its laser oscillation to be impossible. Indeed, the document states that as an electron excited to a first excitation state of the d - d transitions in the fluorescent material is further excited to an upper level, its laser oscillation is not possible.

Thus, while spinel type MgAl₂O₄ fluorescent materials doped with various transition metals have hitherto been tried, no such fluorescent material capable of laser oscillation has been brought to realization.

In view of the problems mentioned above, the first object of the present invention is to provide a transition metal doped spinel type MgAl₂O₄ fluorescent material that is capable of laser oscillation. Also, a second object of the present invention is to provide a transition metal doped MgAl₂O₄ laser apparatus, i. e., a laser apparatus using such a fluorescent material. Further, a third object of the present invention is to provide a method of making a transition metal doped MgAl₂O₄ fluorescent material.

### Disclosure of the Invention

In order to achieve the first object mentioned above, a transition metal doped spinel type MgAl₂O₄ fluorescent material in accordance with the present invention is characterized in that it is made by growing a single-crystal from a source material rod in a selected gaseous atmosphere wherein the source material rod is formed from a mixed raw material of an Al raw material and a Mg raw material added thereto in an amount together with a transition metal raw material so that the amount of Mg exceeds that of Al by a few percents in terms of molar ratio. The said selected gaseous atmosphere may be an oxidizing or inert gas, and the said source material rod can be single-crystallized, preferably using floating zone melting.

The fluorescent material according to the present invention is essentially free from vacancies of Mg or oxygen, and indeed the material undoped with a transition metal, namely the spinel type MgAl₂O₄ matrix crystal itself is high in crystalline perfection to an extent that it has no absorption peak for light of a wavelength ranging from 300 nm to 900 nm.

The fluorescent material according to the present invention may be characterized in that it uses the above-mentioned matrix crystal, and the said transition metal is Ti and the said fluorescent material has a composition expressed by chemical formula MgAl₂₋ₓTiₓO₄ where 0.003 ≦ x ≦ 0.01 and that it has no absorption peak except for its band edge absorption for light wavelengths of 200 nm to 900 nm and it is capable of light emission having a peak at 490 nm by its band edge excitation.

In the Ti doped spinel type MgAl₂O₄ fluorescent material described above, Ti may exist as Ti⁴⁺ at a B site in the spinel type MgAl₂O₄ crystal, and the light emission may occur when the electron of an electron-hole pair generated by band edge excitation is captured by a Ti⁴⁺ to form an intermediate energy state and recombines with a hole captured by an O in the vicinity of the Ti⁴⁺. The light emission may also occur conversely when a hole is captured by an O in the vicinity of a Ti⁴⁺ to form an intermediate energy state and recombines with an electron in the vicinity of the Ti⁴⁺. Since this emission process is not by electric dipole forbidden transition but by charge transfer transition which is one or two order higher in transition probability than the electric dipole forbidden transition in the d-d transition, a fluorescent material provided here is having a high emission efficiency rendering it capable of laser oscillation.

The fluorescent material according to the present invention may also be characterized in that it uses the above-mentioned matrix crystal, and the said transition metal is Mn and the said fluorescent material has a composition expressed by chemical formula Mg₁₋ₓMnₓAl₂O₄ where 0.003 ≦ x ≦ 0.01 and in a wavelength range of 200nm to 900nm it has its band edge absorption and absorption with a peak at 450 nm of which intensity increases as the amount of doped Mn is increased, and it has light emission having a peak at 520 nm by its band edge excitation or excitation at 450 nm and light emission having a peak at 650 nm by its band edge excitation.

In the Mn doped spinel type MgAl₂O₄ fluorescent material described above, the emission at 650 nm is caused by Mn existing as Mn²⁺ at an A site in the spinel type MgAl₂O₄ crystal. The electron of an electron-hole pair generated by band edge excitation is captured by a Mn²⁺ to form an intermediate energy state and recombines with a hole captured by an O in the vicinity of the Mn²⁺. The emission may also occur conversely so that a hole is captured by an O in the vicinity of a Mn²⁺ to form an intermediate energy state and recombines with an electron in the vicinity of the Mn²⁺. Since this emission process is not by electric dipole forbidden transition but by charge transfer transition which is one or two order higher in transition probability than the electric dipole forbidden transition in the d - d transition and also since the emission at 520 nm is caused by both the d - d and charge transfer transitions, the fluorescent material provided here has high emission efficiency rendering it capable of laser oscillation.

The fluorescent material according to the present invention may also be characterized in that the said transition metal doped in the matrix crystal, is V and the said fluorescent material has a composition expressed by chemical formula MgAl₂₋ₓVₓO₄ where 0.001 ≦ x ≦ 0.01 and that it has no absorption peak except for its band edge absorption for a wavelength range of 200 nm to 900 nm and it is capable of white color light emission over wavelengths of 450 nm to 750 nm by its band edge excitation. So composed as described, the V doped spinel type MgAl₂O₄ fluorescent material is a fluorescent material which like the Ti and Mn doped fluorescent materials described above, is high in emission efficiency so as to be capable of laser oscillation.

In order to achieve the second object mentioned above, there is also provided in accordance with the present invention a transition metal doped spinel type MgAl₂O₄ laser apparatus characterized in that it has a laser medium made of a transition metal doped spinel type MgAl₂O₄ fluorescent material discussed above.

The laser apparatus according to the present invention may be characterized in that the laser medium is made of a said Ti doped spinel type MgAl₂O₄ fluorescent material and that the said laser medium is side-pumped with a fourth harmonic of a Nd: YAG laser (having a wavelength of 266 nm), a fourth harmonic of a Nd: YLF (having a wavelength of 262 nm) or a fourth harmonic of a Nd: YAP laser (having a wavelength of 269 nm) and is caused to resonate with an external laser resonator to produce blue or green color laser oscillation light utilizing light emission having the peak at 490 nm of the said fluorescent material.

The laser apparatus according to the present invention may also be characterized in that the said laser medium is a said Mn doped spinel type MgAl₂O₄ fluorescent material and that the said laser medium is side-pumped with a fourth harmonic of a Nd: YAG laser (having a wavelength of 266 nm), a fourth harmonic of a Nd: YLF (having a wavelength of 262 nm) or a fourth harmonic of a Nd: YAP laser (having a wavelength of 269 nm) and is caused to resonate with an external laser resonator to produce blue or green and/or red color laser oscillation utilizing light emission having the peak or peaks at 520 nm and/or 650 nm of the said fluorescent material.

The laser apparatus according to the present invention may also be characterized in that two Ti doped spinel type MgAl₂O₄ fluorescent materials and a Mn doped spinel type MgAl₂O₄ fluorescent material are disposed in series in an external laser resonator and these three fluorescent materials are side-pumped with a fourth harmonic of a Nd: YAG laser (having a wavelength of 266 nm), a fourth harmonic of a Nd: YLF (having a wavelength of 262 nm) or a fourth harmonic of a Nd: YAP laser (having a wavelength of 269 nm) to produce blue and green color laser oscillations, respectively, from the two Ti doped spinel type MgAl₂O₄ fluorescent materials and red color laser oscillation from the Mn doped spinel type MgAl₂O₄ fluorescent material, simultaneously. This setup provides a laser with the three primary colors.

The laser apparatus according to the present invention may also be characterized in that said Ti doped spinel type MgAl₂O₄ fluorescent material and two said Mn doped spinel type MgAl₂O₄ fluorescent materials are disposed in series in an external laser resonator and these three fluorescent materials are side-pumped with a fourth harmonic of a Nd: YAG laser (having a wavelength of 266 nm), a fourth harmonic of a Nd: YLF (having a wavelength of 262 nm) or a fourth harmonic of a Nd: YAP laser (having a wavelength of 269 nm) to produce blue or green color laser oscillation from the Ti doped spinel type MgAl₂O₄ fluorescent material and blue or green and red color laser oscillations, respectively, from the Mn doped spinel type MgAl₂O₄ fluorescent materials, simultaneously. This setup provides a laser with the three primary colors, too.

The laser apparatus according to the present invention may also be characterized in that said Ti doped spinel type MgAl₂O₄ fluorescent material and a Mn doped spinel type MgAl₂O₄ fluorescent material are disposed in series in an external laser resonator and these two fluorescent materials are side-pumped with a fourth harmonic of a Nd: YAG laser (having a wavelength of 266 nm), a fourth harmonic of a Nd: YLF (having a wavelength of 262 nm) or a fourth harmonic of a Nd: YAP laser (having a wavelength of 269 nm) to produce blue or green color laser oscillation from the said Ti doped spinel type MgAl₂O₄ fluorescent material and blue or green and red color laser oscillations from the said Mn doped spinel type MgAl₂O₄ fluorescent material, simultaneously. This setup provides a laser with the three primary colors, too.

In order to achieve the third object mentioned above there is provided in accordance with the present invention, a method of making a transition metal doped spinel type MgAl₂O₄ fluorescent material, characterized in that it comprises: preparing a mixed raw material of an Al raw material and a Mg raw material added thereto in an amount together with a transition metal raw material so that the amount of Mg exceeds that of Al by a few percents in terms of molar ratio, shaping the mixed raw material under pressure to form a source material rod, and growing a single-crystal from the source material rod in a selected gaseous atmosphere by floating zone melting method. The said selected gaseous atmosphere may be an oxidizing or inert gas.

Adopting this method, it is possible to obtain a spinel type MgAl₂O₄ matrix crystal that is essentially free from vacancies of Mg or oxygen and is high in crystalline perfection to an extent, for example, that the material without a transition metal, namely the matrix crystal has no absorption peak for light wavelengths of 300 nm to 900 nm.

If the said Al raw material is Al₂O₃, the said Mg raw material is MgO and the said transition metal raw material is TiO₂ and the raw material TiO₂ is added to the raw material Al₂O₃ at a proportion in a range of 0.003 to 0.01 in terms of molar ratio, it is then possible to make a Ti doped spinel type MgAl₂O₄ fluorescent material that has no absorption peak except for its band edge absorption for light wavelength range from 200 nm to 900 nm and is capable of light emission having a peak at 490 nm by its band edge excitation.

If the said Al raw material is Al₂O₃, the said Mg raw material is MgO and the said transition metal raw material is MnO₂ and the raw material MnO₂ is added to the raw material MgO at a proportion in a range of 0.003 to 0.01 in terms of molar ratio, it is then possible to make a Mn doped spinel type MgAl₂O₄ fluorescent material which besides its band edge absorption, has an absorption peak at 450 nm of which intensity increases proportionally as the amount of doped Mn is increased and which is capable of light emission having a peak at 520 nm by excitation light at 450 nm while having a peak at 650 nm by its band edge excitation.

Also, if the said Al raw material is Al₂O₃, the said Mg raw material is MgO and the said transition metal raw material is a V metal and the V metal raw material is added to the raw material Al₂O₃ at a proportion in a range of 0.001 to 0.01 in terms of molar ratio, it is then possible to make a V doped spinel type MgAl₂O₄ fluorescent material that has no absorption peak except for its band edge absorption for light wavelengths of 200 nm to 900 nm and is capable of white color light emission ranging over wavelengths from 450 nm to 750 nm by its band edge excitation.

Further, a transition metal doped spinel type MgAl₂O₄ fluorescent material may also be made by mixing together a source material Al₂O₃, a source material MgO and a transition metal raw material to form a mixture thereof; shaping under pressure, and sintering the mixture to form a sintered body; and growing epitaxially on a single-crystal substrate a single-crystal thin film of transition metal doped spinel type MgAl₂O₄ fluorescent material by laser ablation using the said sintered body as a target in an O₂ gas.

### Brief Description of the Drawings

In the drawings:
Fig. 1 is a conceptual view illustrating a diagrammatic cross section of a hydrostatic forming apparatus for use in making a transition metal doped spinel type MgAl₂O₄ fluorescent material according to the present invention;
Fig. 2 is a diagram conceptually illustrating a floating zone melting furnace for use in the making according to the present invention;
Fig. 3 is a view illustrating a diagrammatic cross section of a die set for use in the making according to the present invention;
Fig. 4 is a diagrammatic cross sectional view illustrating an electric furnace heating system that is a sintering apparatus for use in the making according to the present invention;
Fig. 5 is a conceptual view of a laser ablation apparatus for use in the making according to the present invention;
Fig. 6 is a graph showing emission spectra of light emissions by band edge excitation of matrix crystals according to the present invention;
Fig. 7 is a graph showing transmittance characteristics of a matrix crystal and Ti doped fluorescent materials according to the present invention;
Fig. 8 is a graph showing emission spectra of light emissions by band edge excitation light of Ti doped fluorescent materials according to the present invention;
Fig. 9 is graph showing time resolved emission spectra of a light emission spectrum having a peak at 490 nm of a Ti doped fluorescent materials according to the present invention;
Fig. 10 is a graph showing transmittance characteristics of Mn doped fluorescent materials according to the present invention;
Fig. 11 is a graph showing emission spectra of light emissions by 450 nm excitation light of Mn doped fluorescent materials according to the present invention;
Fig. 12 is a graph showing excitation spectra of emission spectra probed at a peak of 520 nm of Mn doped fluorescent materials according to the present invention;
Fig. 13 is a graph showing time resolved spectra of an emission spectrum having a peak at 520 nm of a Mn doped fluorescent material according to the present invention;
Fig. 14 is a graph showing emission spectra of light emissions by band edge excitation of Mn doped fluorescent materials according to the present invention;
Fig. 15 is a graph showing time resolved spectra of an emission spectrum having a peak at 650 nm of a Mn doped fluorescent material according to the present invention;
Fig. 16 is a graph showing emission spectra of light emissions by band edge excitation of V doped fluorescent materials according to the present invention;
Fig. 17 is a picture showing a RHEED (reflection high-energy electron diffraction) pattern of a thin film single crystal fluorescent material of MgAl₂₋ₓTiₓO₄ grown epitaxially on a SrTiO₃ (100) substrate.
Fig. 18 is a chart showing an X-ray diffraction pattern of the thin film single crystal fluorescent material of MgAl₂₋ₓTiₓO₄;
Fig. 19 is a photograph showing fluorescence emitted from thin film single crystal fluorescent material of MgAl₂₋ₓTiₓO₄ when it is excited by an electron beam;
Fig. 20 shows embodiments in makeup of a transition metal doped spinel type fluorescent material laser apparatus according to the present invention;
Fig. 21 is a photograph showing laser oscillations of a Ti doped spinel type fluorescent material laser apparatus of the present invention; and
Fig. 22 shows laser oscillations of a Mn doped spinel type fluorescent material laser apparatus of the present invention.

### Best Modes for Carrying Out the Invention

The present invention will better be understood from the following detailed description and the drawings attached hereto showing certain illustrative forms of implementation of the present invention. Therefore, it should be noted that such forms of implementation illustrated in the accompanying drawings hereof are intended in no way to limit the present invention but to facilitate an explanation and understanding thereof.

Mention is first made of a method of making a fluorescent material according to the present invention.

A method of making a fluorescent material in accordance with the present invention comprises the step of mixing an aluminum oxide raw material, a magnesium oxide raw material and a transition metal raw material together, the step of shaping the mixture under pressure to form a source material rod, and a melt growth step of placing the source material rod on a seed rod of the source material in a floating zone melting furnace and growing single-crystal by a floating zone melting method in a gaseous atmosphere.

Mention is now made of a pressure forming apparatus for use in the making method of the present invention.

Fig. 1 is a conceptual view illustrating a diagrammatic cross section of a pseudo-hydrostatic forming apparatus. In Fig. 1, the pseudo-hydrostatic forming apparatus, designated by reference character 10, comprises a cylinder 11 filled with water 15, a piston 13 and an oil hydraulic press (not shown). And, a source material mixture 17 formed into a columnar shape, e. g., by being packed into a tube type balloon (with a diameter of about 6 mm and a length of about 250 mm), is placed in the water 15 and compressed and shaped when the piston 13 is pushed by the oil hydraulic press. This process gives a source material rod of a suitable length shown as the mixture 17. In this case, the oil hydraulic press exerts a load of, e. g., 300 kg/cm², and the source material rod has a length of, e. g., 50 to 100 mm while a seed rod is of a length of, e. g., 20 to 50 mm.

Mention is next made of a floating zone melting furnace for use in making of a fluorescent material of the present invention. Fig. 2 is a conceptual view illustrating such a floating zone melting furnace. In Fig. 2, the floating zone melting furnace, designated by reference character 20, comprises a fused silica tube 23 in which to maintain a gaseous atmosphere therein, argon or oxygen gas or both can be introduced from a gas supply system such as a cylinder (not shown). It also includes a pair of shafts 21 and 21 which hold between them a seed rod 22 lying lower and a source material rod 26 lying upper in the fused silica tube 23 and which are jointly rotatable and movable vertically. Included further are a spheroidal bifocal mirror 27, an infrared convergent heating source 25 such as a xenon lamp disposed at one focal position of the bifocal mirror 27, and a window for observation (not shown). And, the floating zone melting furnace 20 is associated with a computer (not shown) for controlling the rotary and vertical movements of the shafts 21 and 21 and their heating temperature and rates of temperature rise and fall.

Further, an end of the seed rod 22 held by one of the shafts 21 and an end of the source material rod 26 held by the other shaft 21 are positioned to lie at the other or second focal position of the spheroidal mirror 27 so that by controlling vertical movement of the shafts 21 and 21 allows a desired growth. In Fig. 2, note also that infrared rays 29 are drawn in order to show the condensation of light at the second focal position of the spheroidal mirror 27.

In the floating zone melting furnace 20 constructed as mentioned above, after heating and melting these ends of the seed rod 22 and source material rod 26, two ends are contacted to form a melt zone 24. Thus the shafts 21 and 21 are slowly moved downwards to move the melt zone gradually towards the source material rod to allow a single crystal to be growing on the seed rod.

Thus, in the floating zone melting method in accordance with the present invention, a MgAl₂O₄ single crystal having a spinel type crystallographic structure and doped with a transition metal at its adequate positions in matrix crystal can be made in a short period of time and moreover in a size of, e. g., a diameter of 5 mm and a length of 100 mm or more. Furthermore, without the need to use a crucible to hold a melt, it is possible to make such a single crystal that is free of contamination by impurities and that has a same concentration for the transition metal as in the source material.

Mention is next made of a method and an apparatus for making a sintered target for laser ablation that may be used in the making of a fluorescent material according to the present invention.

The method of making such a sintered target comprises a mixing step of mixing an aluminum oxide raw material, a magnesium oxide raw material and a transition metal raw material together, a compression molding step of forming the mixed source material to prepare a target shaped body and a sintering step of heating the formed body in a given gaseous atmosphere to make the sintered target.

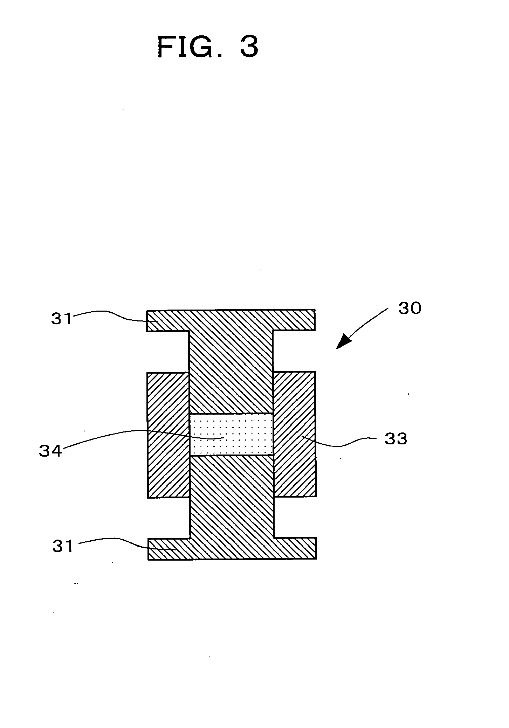

Mention is next made of a pressure forming apparatus for compression molding that may be used in the making of a fluorescent material according to the present invention. Fig. 3 is a conceptual cross sectional view illustrating such a die set. In the Figure, a mould or die set 30 is shown comprising a metal cylinder 33 loaded with a mixture or mixed source material 34, a pair of an upper and a lower pistons 31 and 31 and a pressing unit (not shown) that applies pressure to the pistons 31 and 31 upward and downward. Pressing is cold pressing.

Mention is next made of a sintering apparatus for use in the making of a fluorescent material according to the present invention.

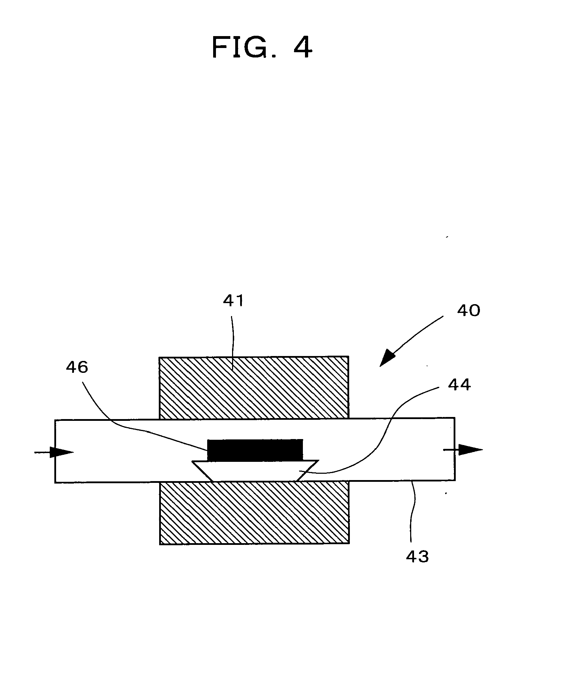

Fig. 4 is a conceptual view diagrammatically illustrated cross section of an electric furnace heating system that constitutes the sintering apparatus. In Fig. 4, the electric furnace heating system, designated by reference character 40, comprises an electric furnace of cylinder type 41, an aluminum core tube 43 that withstands high temperature, a gas supply subsystem (not shown) for supplying a gas into the core tube 43 and a vacuum pumping subsystem (not shown) that permits pumping up to high vacuum. The electric furnace heating system 40 also controls its degree of vacuum, heating temperature and rising and falling rates of temperature. The vacuum pumping subsystem may use, for example, a combination of oil diffusion and rotary pumps.

In such an arrangement as shown in Figs. 3 and 4, first a space formed of the pistons 31 and the metal cylinder 33 is filled with a source material mixture 34, and when a load, e. g., of 200 kg/cm², is applied to the pistons 31 and 31 from both sides to compress and mold the source material mixture 34, a formed body 46 is produced, having a diameter of 20 mm and a thickness of 5 mm, for example.

Next, the compression-molded formed body 46 is placed on an alumina ceramic boat 44 and then placed in the core tube 43. The core tube 43 is then supplied with a selected gas while evacuated as indicated by the arrows in Fig. 4 while sintering proceeds. In this way, a sintered body is formed under a selected temporal profile of temperature in the electric furnace 41.

A sintered body made in such a method is shaped as desired shape in the stage of pressure molding and thus can have a shape suitable for its intended use.

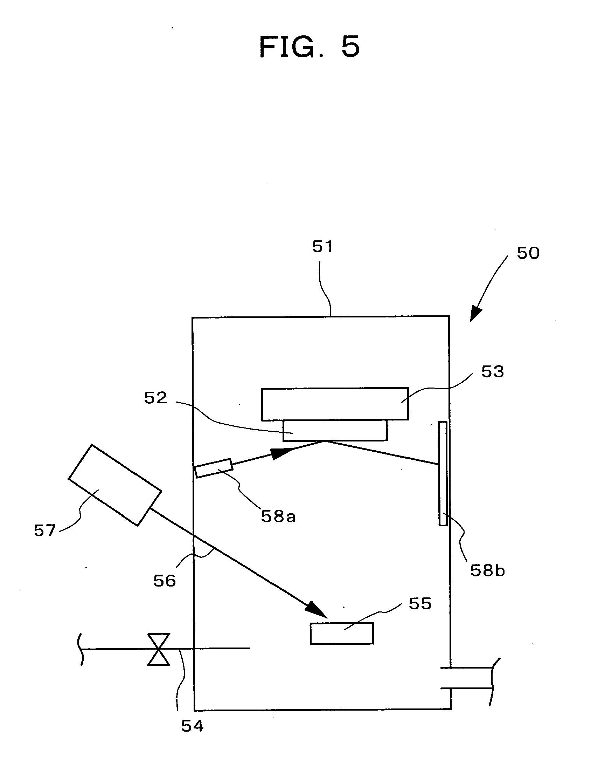

Mention is next made of a laser ablation apparatus for use in the making of a fluorescent material according to the present invention. Fig. 5 is a conceptual view of a laser ablation apparatus. The laser ablation apparatus, indicated by reference character 50, comprises a vacuum chamber 51, a substrate retaining and heating unit 53 that holds a substrate 52 and controls its temperature in the vacuum chamber 51, and a gas supply unit 54 for introducing a gas into the vacuum chamber 51. It also includes a target 55 whose material is to be vapor-deposited on the substrate 52 and a laser light source for laser ablation 57 disposed outside of the vacuum chamber 51 for irradiating the target 55 with a pulsed laser light 56 to vaporize the target material therefrom. The apparatus 50 further includes a RHEED (reflection high-energy electron diffraction) unit 58 made of an electron gun 58a and an electron beam detector 58b for analyzing a structure of the material vapor-deposited on the substrate 52, which makes it possible to control the film thickness of the vapor-deposited material (from the target 55) in an atomic layer unit. Using this unit allows obtaining a vapor-deposited thin film that has a same composition as that of the target material.

A thin film crystalline fluorescent material according to the present invention may be made by using this apparatus holding a single crystal substrate 52 at a selected temperature while laser-ablating material from the target for vapor deposition on the substrate 52, the target being a sintered body made by sintering a mixture of an aluminum oxide material, a magnesium oxide material and a transition metal material which are put together in selected concentrations.

An explanation is next given of properties of a transition metal doped spinel type MgAl₂O₄ fluorescent material by way of several specific examples.

### Example 1

An aluminum oxide (Al₂O₃) material and a magnesium oxide (MgO) material were mixed together and a mixture thereof was compression-molded in a pressure forming apparatus as shown in Fig. 1 to prepare a rod of source material, which was placed in a floating zone melting furnace as shown in Fig. 2 to single-crystallize the source material by the floating zone melting method in gaseous atmosphere. A resultant MgAl₂O₄ matrix crystal was irradiated with a ray of ultraviolet light having a peak at 360 nm and its emission spectrum was observed.

In this case, several specimens grown by floating zone melting method with varying the mixing ratio of the aluminum oxide (Al₂O₃) material and magnesium oxide (MgO) material and with variously changing the gaseous atmosphere were prepared and their emission spectra were compared.

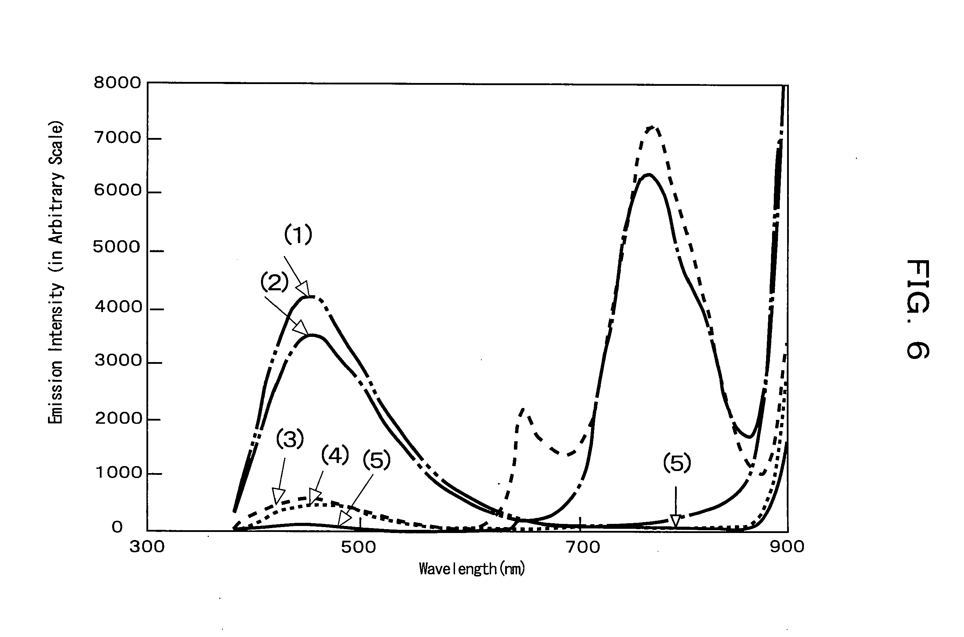

Fig. 6 is a graph comparing the emission spectra of MgAl₂O₄ matrix crystals grown with the different conditions, when they were excited with a band edge excitation light of 275 nm. In the graph, the abscissa axis represents the light wavelength for fluorescence and the ordinate axis represents the emission intensity in an arbitrary scale. Curves (1) to (4) in the graph indicate the emission spectra of specimens which were grown by floating zone melting from a source material rod made of the aluminum oxide (Al₂O₃) and magnesium oxide (MgO) materials mixed together so that they are present in an equal amount in terms of molar ratio, in (1) a gaseous atmosphere of mixed Ar and H₂ gases (with H₂ at a volume proportion of 2.4 %), (2) an atmosphere of O²⁺ ion gas, (3) a gaseous atmosphere of O₂ gas and (4) an atmosphere of Ar gas, respectively. Curve (5) indicates the emission spectrum of a specimen which was grown by floating zone melting from a source material rod made of the aluminum oxide (Al₂O₃) and magnesium oxide (MgO) materials mixed together so that the amount of MgO exceeds that of Al₂O₃ by 1 % in terms of molar ratio in an atmosphere of O₂ gas.

As is seen from the graph, from the specimens in which the aluminum oxide (Al₂O₃) and magnesium oxide (MgO) materials are mixed together in an equal amount in terms of molar ratio, light emissions are observed over the entire visible light range, regardless of the types of gaseous atmosphere. On the other hand, from the specimen (5) in which the aluminum oxide (Al₂O₃) and magnesium oxide (MgO) materials are mixed together so that the amount of MgO exceeds that of Al₂O₃ by 1 % in terms of molar ratio, very weak light emission is observed over the entire visible light range. Also although not shown, note here that from a specimen prepared replacing the gaseous atmosphere with Ar gas, likewise very weak light emission was observed over the entire visible light range.

It is seen, therefore, that an excellent optical crystal is obtained if a mixed source material is made by mixing an Al raw material with a Mg raw material so that an amount of Mg exceeds that of Al in terms of molar ratio a few percents, by pressure-molding the mixed source material into a source material rod and by single-crystallizing the source material rod by the floating zone melting method in an oxygen or Ar gas.

### Example 2

Several source material rods were prepared from mixed source materials containing an aluminum oxide (Al₂O₃) material and a magnesium oxide (MgO) material in a proportion such that an amount of MgO exceeds that of Al₂O₃ by 1 % in terms of molar ratio, and containing with various amounts of TiO₂ as the transition metal material added thereto, and the source material rods were single-crystallized in an Ar or O₂ gas by the floating zone melting method to form fluorescent materials, and their properties were measured.

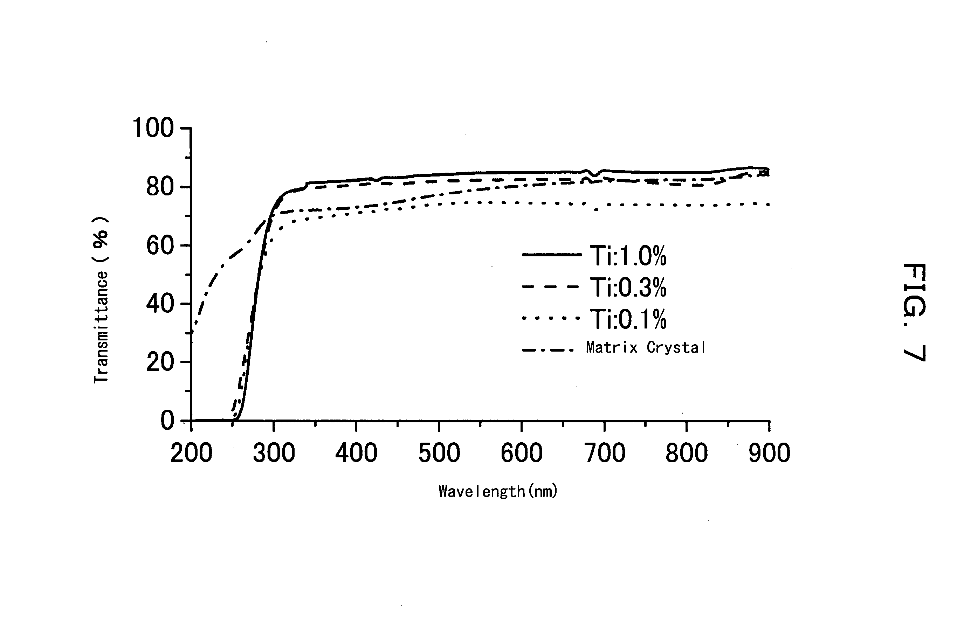

Fig. 7 is a graph showing transmittance characteristics of a matrix crystal and Ti doped fluorescent materials according to the present invention. In the graph, the abscissa and ordinate axes represent the light wavelength and transmittance, respectively. The dashed dotted line indicates the transmittance of the matrix crystal while the dotted line, the dashed line and the solid line indicate the transmittances of the fluorescent materials doped with Ti at 0.1 %, 0.3 % and 1 % in terms of molar ratio to Al₂, respectively.

From Fig. 7, it is seen that the matrix crystal has no absorption peak in a wavelength range of 200 nm to 900 nm except for the band edge absorption and has property needed for an optical crystal. It is also seen that a fluorescent material doped with Ti has no absorption peak in a wavelength range of 200 nm to 900 nm except for the band edge absorption. It is further seen that the transmittance rises as the Ti doping amount is increased.

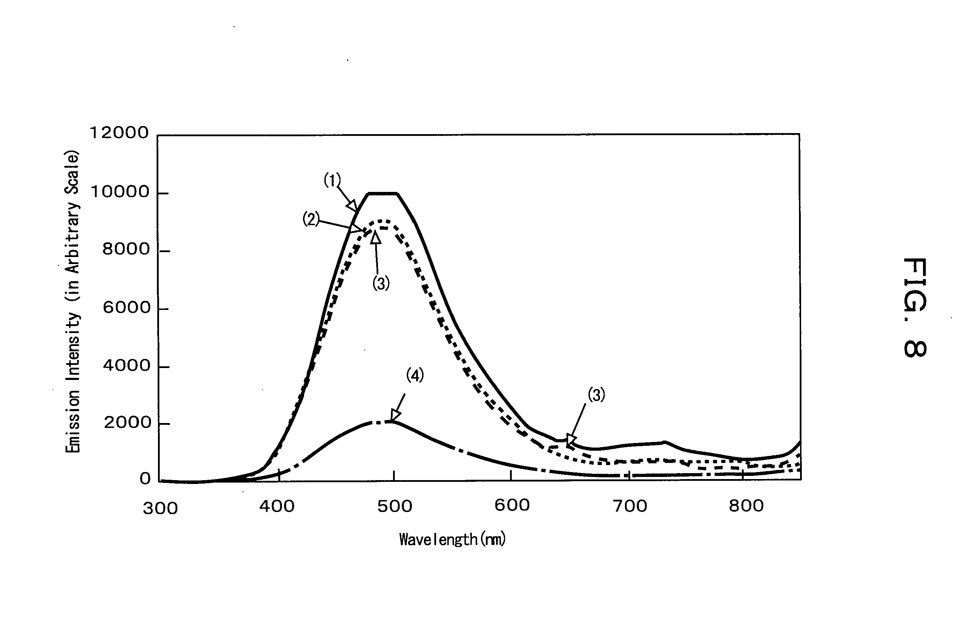

Fig. 8 is a graph showing spectra of light emissions by band edge excitation light of Ti doped fluorescent materials according to the present invention. In the graph, the abscissa axis represents the emission wavelength and the ordinate axis represents the emission intensity in an arbitrary scale. Curve (1), curve (2), curve (3) and curve (4) indicate the emission spectra of the fluorescent materials doped with Ti at 0.3 %, 0.5 %, 1 % and 0.1 % in terms of molar ratio to Al₂, respectively. The band edge excitation light used was an ultraviolet ray of a wavelength around 275 nm where the emission efficiency is the highest. Note here that the flattened peak of the solid curve (1) is due to a limit of measurement by the measuring device.

From this graph it is seen that these fluorescent materials are fluorescent materials which by the band edge excitation produce light emissions having a peak at 490 nm and a full width at half minimum of about 130 nm and that their fluorescence intensity becomes the highest when the Ti concentration ranges between 0.3 % and 1 %.

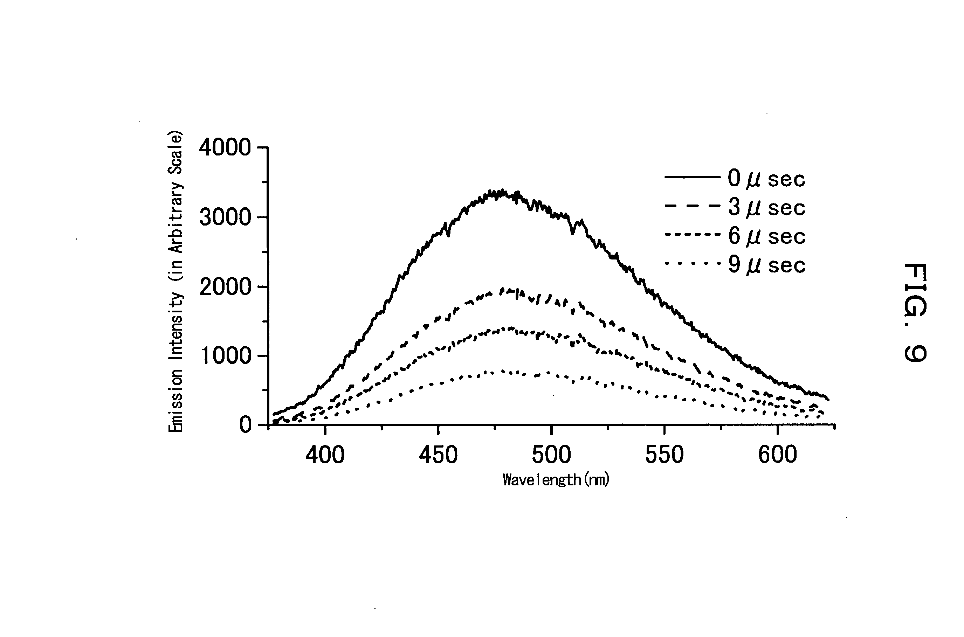

Fig. 9 is a graph showing time resolved spectra of a light emission spectrum having a peak at 490 nm of a Ti doped fluorescent material. In the graph, the abscissa axis represents the emission spectral wavelength and the ordinate axis represents the emission intensity in an arbitrary scale. A fluorescent material doped with Ti at 0.3 % was irradiated with ultrashort light pulses having a center wavelength of 275 nm to measure changes of the 490 nm emission spectrum with time. Respective spectra at successive delays of time after the irradiation are shown, which are designated by different type lines, and these delays of time are indicated in the graph.

From this graph, it is seen that the emission spectrum has a time constant of about 9 microseconds. And, from the fact that the time constant is in the order of microseconds, it is seen that the emission mechanism is not due to the d-d transition by d electron of Ti, because the d-d transition that is an electric dipole forbidden transition requires time constant to be in the order of milliseconds. Also, from the ESR (electron spin resonance) measurement which has confirmed that Ti of this fluorescent material exists as Ti⁴⁺ at a B site in the spinel type MgAl₂O₄ crystal, it is inferred that the light emission occurs when the electron of an electron-hole pair generated by band edge excitation is captured by a Ti⁴⁺ to form an intermediate energy state and recombines with a hole captured by an O in the vicinity of the Ti⁴⁺. The light emission may also occur conversely when a hole is captured by an O in the vicinity of a Ti⁴⁺ to form an intermediate energy state and recombines with an electron in the vicinity of the Ti⁴⁺. Since this emission mechanism is not by electric dipole forbidden transition but by charge transfer transition which is one or two order higher in transition probability than d-d transition in the electric dipole forbidden transition, it is seen that a fluorescent material is provided here having a high emission efficiency rendering it capable of laser oscillation.

### Example 3

Several source material rods were prepared from mixed source materials containing an aluminum oxide (Al₂O₃) material and an magnesium oxide (MgO) material in a proportion such that an amount of MgO exceeds that of Al₂O₃ by 1 % in terms of molar ratio with various amounts of MnO₂ as the transition metal material added thereto, and the source material rods were single-crystallized in an Ar or O₂ gas by the floating zone melting method to form fluorescent materials, and their properties were measured.

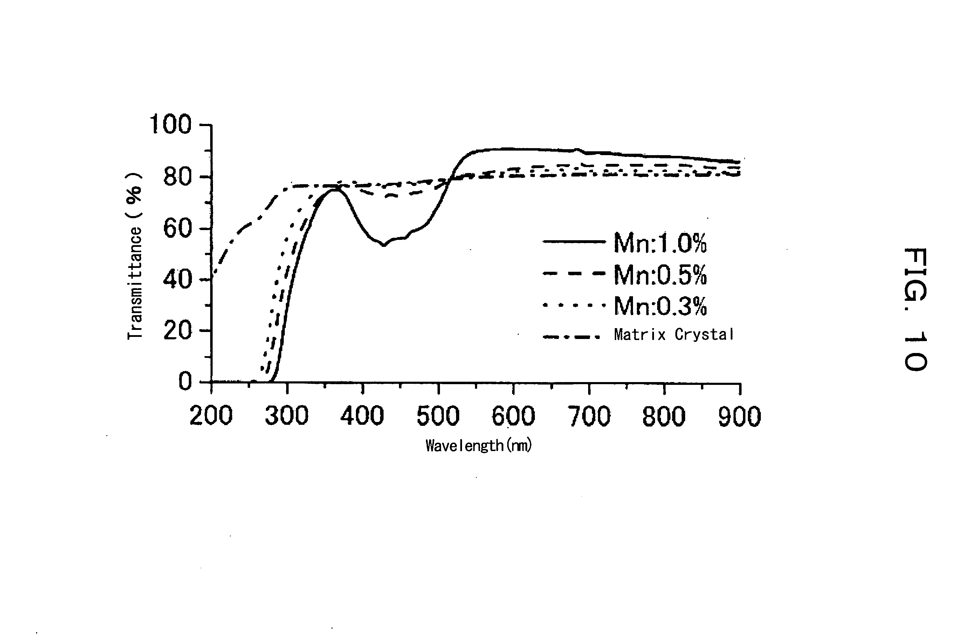

Fig. 10 is a graph showing transmittance characteristics of Mn doped fluorescent materials according to the present invention. In the graph, the abscissa and ordinate axes represent the light wavelength and transmittance, respectively. The dashed dotted line indicates the transmittance of the matrix crystal while the dotted line, the dashed line and the solid line indicate the transmittances of the fluorescent materials doped with Mn at 0.3 %, 0.5 % and 1 % in terms of molar ratio to Mg, respectively. From the graph, it is seen that the fluorescent materials doped with Mn at 0.3 % or less has no absorption peak over a wavelength range of 200 nm to 900 nm except for the band edge absorption. It is further seen that the transmittance rises as the Mn doping amount is increased, the absorption increases at around 450 nm and the transmittance rises in a wavelength range of 500 nm or longer. This phenomenon is presumably due to the fact that a portion of Mg sites in the spinel type MgAl₂O₄ crystal is filled with Mn.

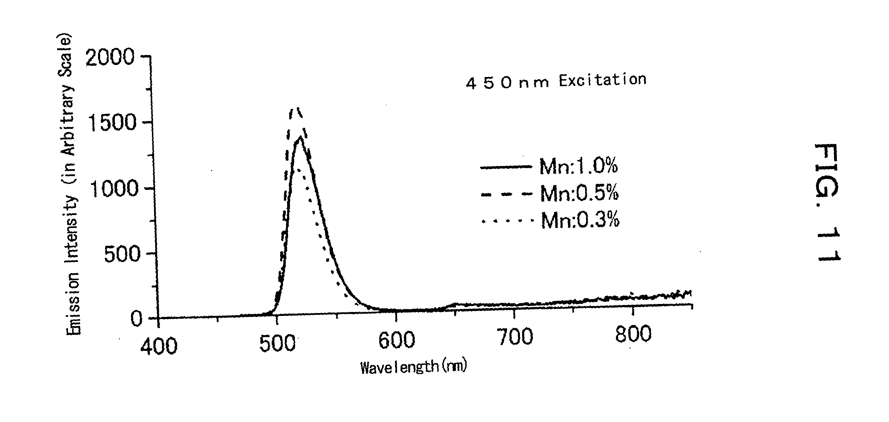

Fig. 11 is a graph showing spectra of light emissions by 450 nm excitation light of Mn doped fluorescent materials according to the present invention. In the graph, the abscissa axis represents the light wavelength and the ordinate axis represents the light intensity. The dotted line, the dashed line and the solid line indicate the emission spectra of the fluorescent materials doped with Mn at 0.3 %, 0.5 % and 1 % in terms of molar ratio to Mg, respectively. From the graph, it is seen that the 450 nm excitation produces light emissions having a peak at 520 nm and a full width at half maximum of 30 nm. Note here that though not shown, it has been confirmed that an emission peak at 520 nm is produced by band edge excitation, too, with a quantum efficiency of the same degree.

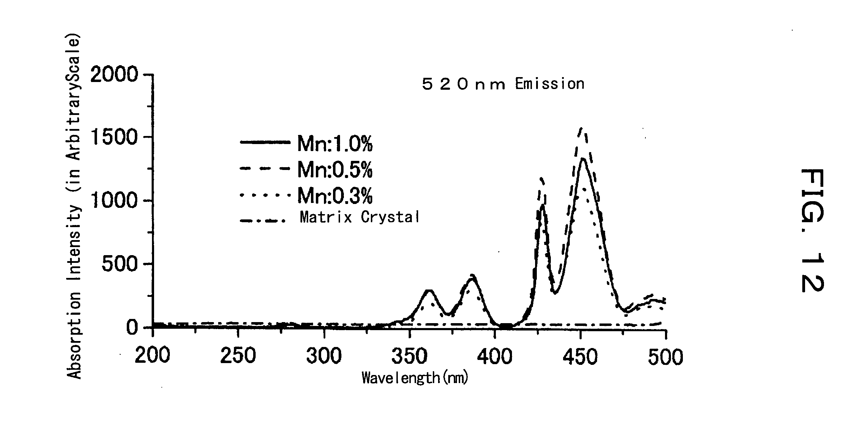

Fig. 12 is a graph showing excitation spectra of emission spectra having a peak at 520 nm of Mn doped fluorescent materials according to the present invention. In the graph, the abscissa axis represents the wavelength of excitation light and the ordinate axis represents the intensity of excitation light in an arbitrary scale. The dotted line, the dashed line and the solid line indicate the excitation spectra of fluorescent materials doped with Mn at 0.3 %, 0.5 % and 1 % by molar ratio to Mg. From the graph it is seen that there exist two excitation peaks at around 450 nm and two excitation peaks at 400 nm or less.

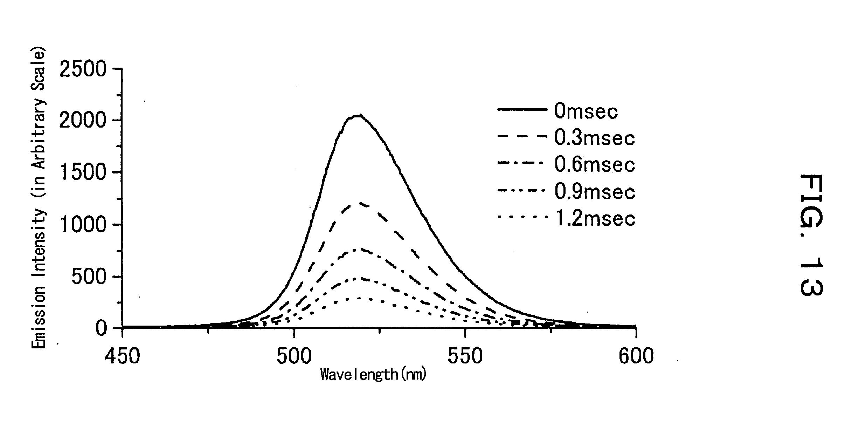

Fig. 13 is a graph showing time resolved spectra of an emission spectrum having a peak at 520 nm of a Mn doped fluorescent material according to the present invention. The abscissa axis represents the wavelength of an emission spectrum and the ordinate axis represents the emission intensity in an arbitrary scale. The fluorescent material doped with Mn at 0.3 % was irradiated with ultrashort light pulses having a central wavelength of 520 nm, and changes of the emission spectrum of 520 nm with time were measured. Respective spectra at successive delays of time after the irradiation are shown, which are designated by different line types, and these delays of time are indicated in the graph.

From this graph, it is seen that the emission spectrum has a time constant as long as about 1 millisecond. From the four excitation spectra in Fig. 12 and the time constant from Fig. 13, it is seen that the emission mechanism is based on d-d transitions in the ligand field of 4 oxygens, by d electrons of Mn²⁺ ions positioned at A sites in the spinel type crystal. Since most of d-d transitions are electric dipole forbidden transitions, the time constant is long. Though not shown, it has also been confirmed that the emission when by band edge excitation has a time constant in the order of microseconds, indicating that charge transfer transitions are brought about in this case.

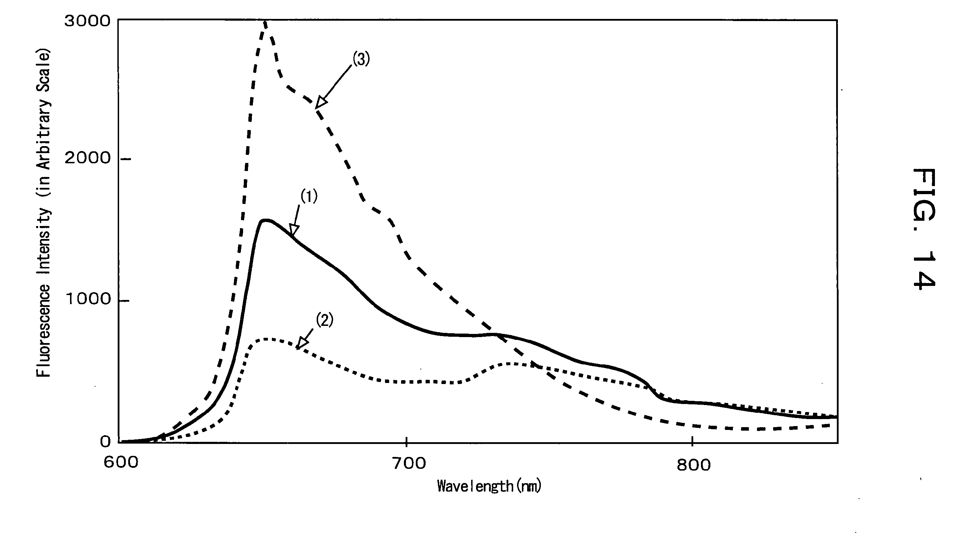

Fig. 14 is a graph showing spectra of light emissions by band edge excitation of Mn doped fluorescent materials according to the present invention. In the graph, the abscissa axis represents the emission wavelength and the ordinate axis represents the emission intensity in an arbitrary scale. In the graph, curve (1), curve (2) and curve (3) indicate the emission spectra of the fluorescent materials doped with Mn at 0.3 %, 0.5 % and 1 % in terms of molar ratio to Mg, respectively. The band edge excitation light source used was a source of an ultraviolet ray of a wavelength around 260 nm where the emission efficiency is the highest. From the graph, it is seen that these fluorescent materials produce by the band edge excitation light emissions whose spectra having a peak at 650 nm and a full width at half maximum of about 70 nm and their fluorescence intensity is the highest when the Mn concentration ranges between 0.3 % and 1 %.

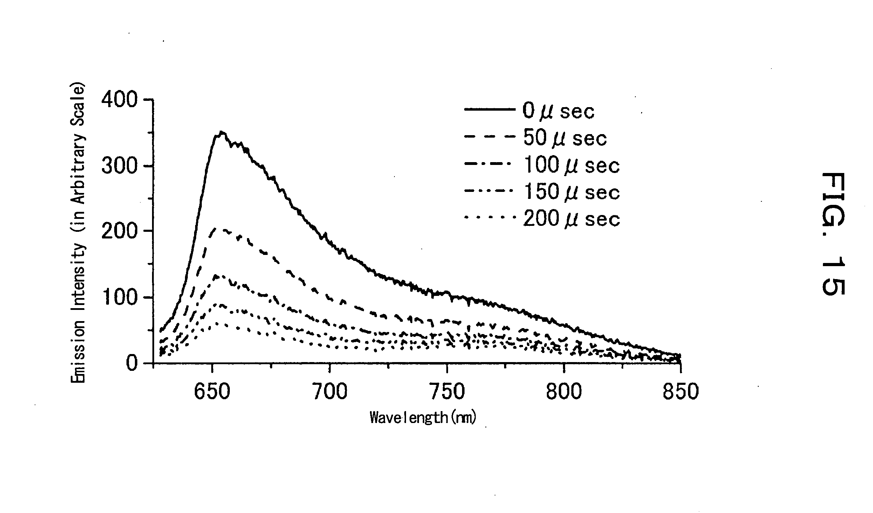

Fig. 15 is a graph showing time resolved spectra of an emission spectrum having a peak at 650 nm of a Mn doped fluorescent material according to the present invention. The abscissa axis represents the emission spectral wavelength and the ordinate axis represents the emission intensity in an arbitrary scale. The fluorescent material doped with Mn at 0.3 % was irradiated with ultrashort light pulses having a wavelength of 260 nm, and changes of the emission spectrum of 650 nm with time were measured. Respective spectra at successive delays of time after the irradiation are shown and identified with different types of lines with indications of these delays of time in the graph for the spectra. From this graph, it is seen that the emission spectrum having a peak at 650 nm has a time constant in the order of several tens microseconds.

From this attenuation constant, it is inferred that the emission at 650 nm occurs by Mn existing as Mn²⁺ at an A site in the spinel type MgAl₂O₄ crystal, the electron of an electron-hole pair generated by band edge excitation is captured by a Mn²⁺ to form an intermediate energy state and recombines with a hole captured by an O in the vicinity of the Mn²⁺. Conversely, it is inferred that it occurs so that a hole is captured by an O in the vicinity of a Mn²⁺ to form an intermediate energy state and recombines with an electron in the vicinity of the Mn²⁺. Since this emission process is not by electric dipole forbidden transition and it is one or two order higher in transition probability than d-d transition in the electric dipole forbidden transition, it is seen that a fluorescent material is provided here having a high emission efficiency rendering it capable of laser oscillation.

### Example 4

Several source material rods were prepared from mixed source materials containing an aluminum oxide (Al₂O₃) material and a magnesium oxide (MgO) material in a proportion such that an amount of MgO exceeds that of Al₂O₃ by 1 % in terms of molar ratio with various amounts of a V metal as the transition metal material added thereto and the source material rods were single-crystallized in an Ar or O₂ gas by the floating zone melting method to form fluorescent materials, and their properties were measured.

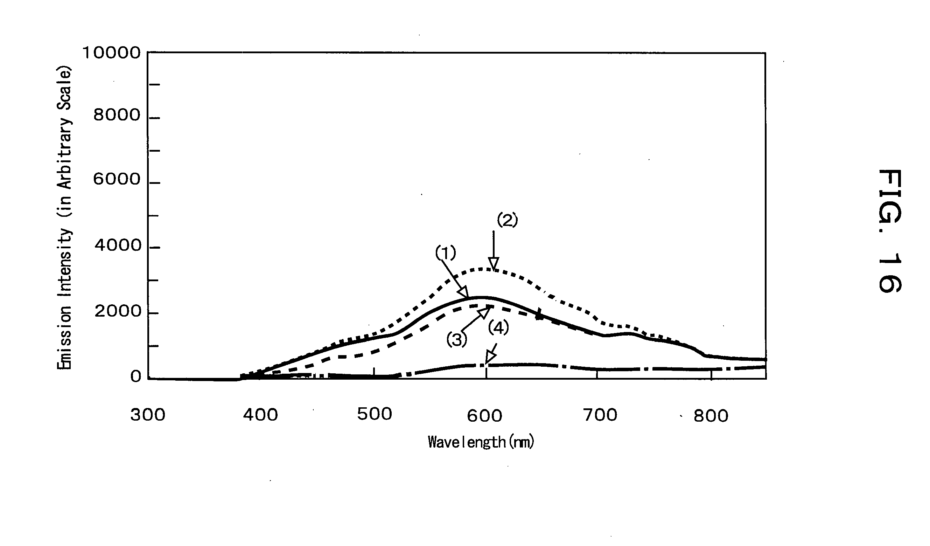

Fig. 16 is a graph showing emission spectra of light emissions by band edge excitation of V doped fluorescent materials according to the present invention. In the graph, the abscissa axis represents the fluorescence wavelength and the ordinate axis represents the fluorescence intensity in an arbitrary scale. In the graph, curve (1), curve (2), curve (3) and curve (4) indicate the emission spectra of the fluorescent materials doped with V at 0.1 %, 0.3 %, 1 % and 3 % in terms of molar ratio to Al₂, respectively. The excitation source used was a source of an ultraviolet ray of a wavelength around 330 nm where the emission efficiency is the highest. From the graph, it is seen that these fluorescent materials produce white fluorescent emissions over a wavelength range from 450 nm to 750 nm and that their fluorescence intensity is the highest when the V concentration ranges between 0.1 % and 1 %.

### Example 5

Using as a target a sintered body of a mixed raw material containing Mg, Al, Ti and O in a chemical equivalent ratio according to composition formula: MgAl₂₋ₓTiₓO₄ where 0.003≦ x≦ 0.01, a thin film single crystal fluorescent material was epitaxially grown on a SrTiO₃ (100) substrate by laser ablation in an O₂ gas and its properties were measured.

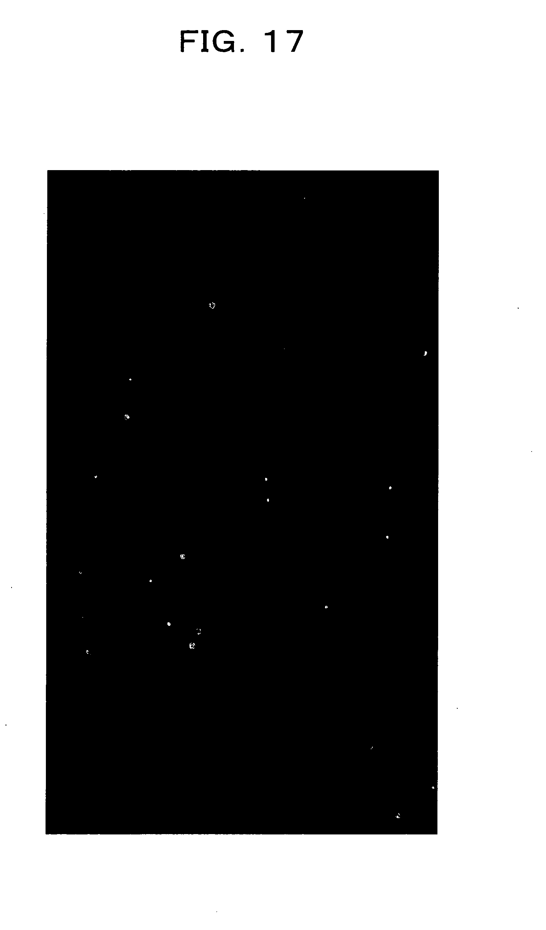

Fig. 17 is a picture showing a RHEED (reflection high-energy electron diffraction) pattern of the thin film single crystal fluorescent material of MgAl₂₋ₓTiₓO₄ grown epitaxially on the SrTiO₃ (100) substrate. From this diffraction pattern, it is seen that the thin film single crystal fluorescent material of the present invention is a single crystalline thin film.

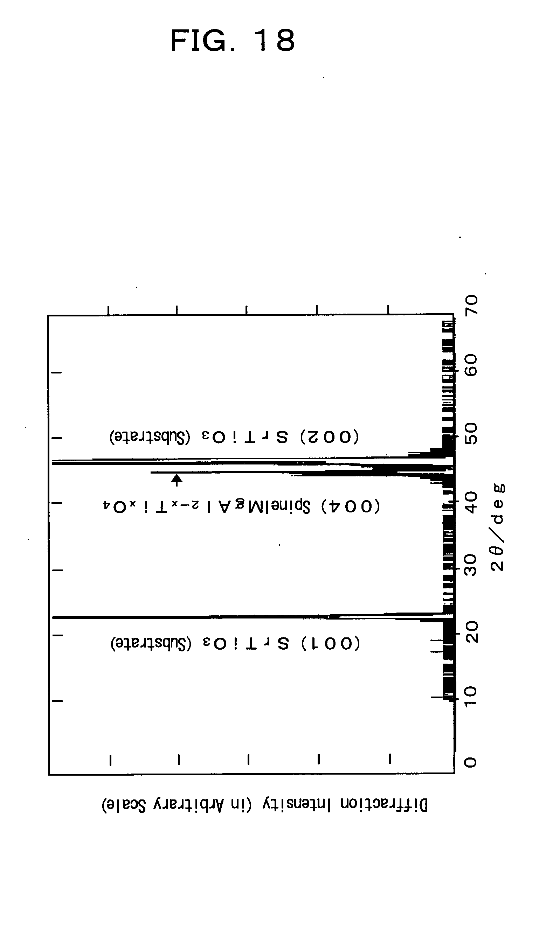

Fig. 18 is a chart showing an X-ray diffraction pattern of the thin film single crystal fluorescent material of MgAl₂₋ₓTiₓO₄. From the chart it is seen that the thin film formed here is a Ti doped spinel type MgAl₂O₄ single crystalline thin film.

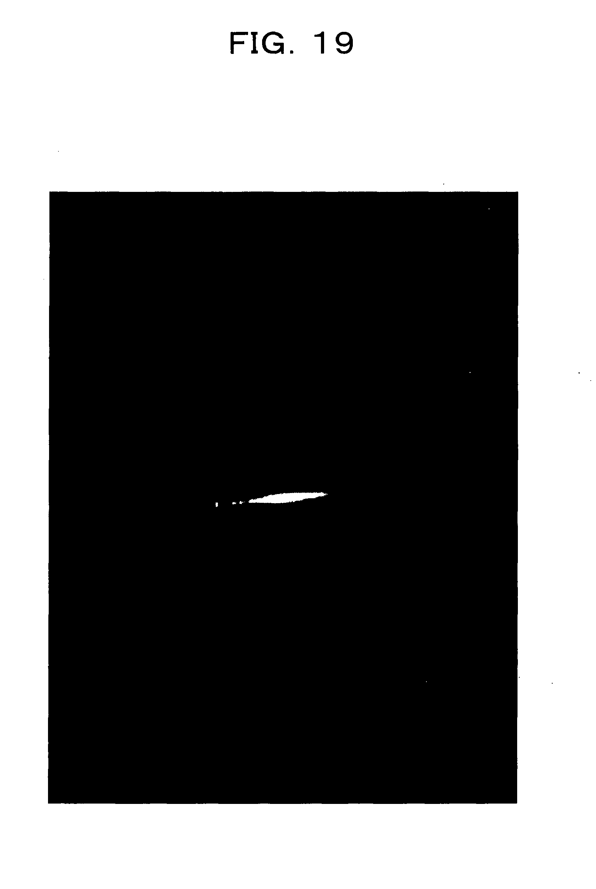

Fig. 19 is a photograph showing fluorescence emitted from the thin film single crystal fluorescent material of MgAl₂₋ₓTiₓO₄ when it is excited by an electron beam energized with an accelerating voltage of 20 keV and applied from the rear surface of the substrate. From the picture, it is seen that strong blue emission is obtained.

Mention is next made of a laser apparatus having its laser medium formed of a transition metal doped spinel type MgAl₂O₄ fluorescent material according to the present invention.

The laser apparatus in accordance with the present invention has its laser medium made of a Ti, Mn, or V doped spinel type MgAl₂O₄ fluorescent material according to the present invention as mentioned above.

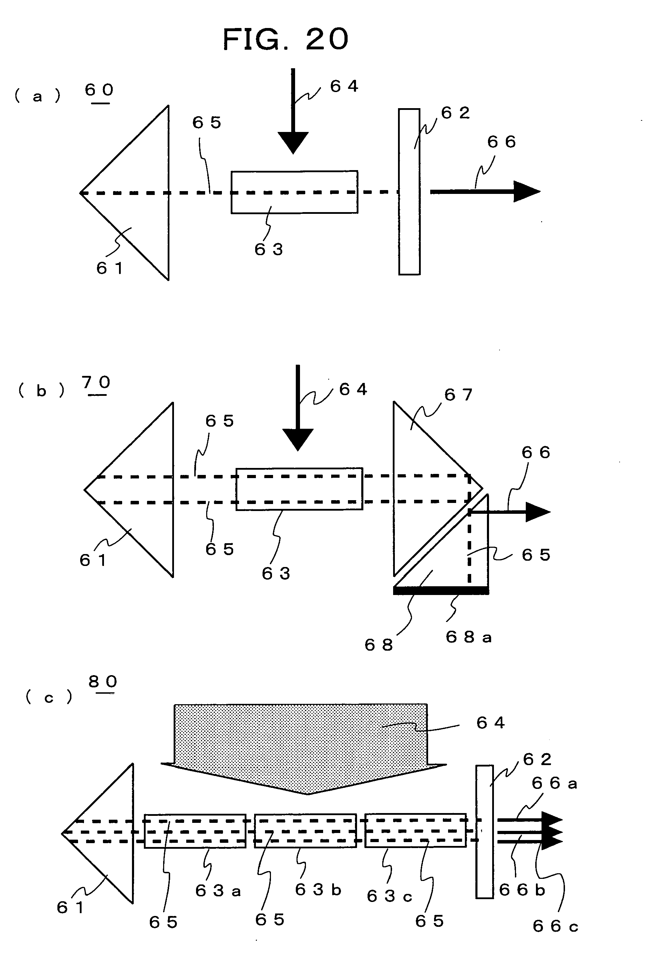

Fig. 20 shows embodiments in setup of the laser apparatus according to the present invention. As shown in Fig. 20(a) a laser apparatus 60 of the present invention includes a resonator comprising a servo prism 61 and a semi-transparent mirror 62 and a laser medium 63 disposed in the resonator and made of a spinel type MgAl₂O₄ fluorescent material doped with Ti, Mn or V whereby irradiating the laser medium laterally with excitation light 64 produces resonant light 65 and causes laser oscillation light 66 to be emitted.

As shown in Fig. 20(b) a laser apparatus 70 of the present invention has the laser medium 63 of spinel type MgAl₂O₄ fluorescent material doped with Ti, Mn or V disposed in a resonator made of the prism 61 and a prism 67 and includes a broadband prism 68 laterally coupled to the prism 67 whereby irradiating the laser medium 63 laterally with excitation light 64 produces resonant lights 65 and causes laser oscillation light 66 to be emitted laterally from the broadband prism 68. Here, the bottom surface of the broadband prism 68 has a reflection film 68a of 100% reflectance.

Further, as shown in Fig. 20(c) a laser apparatus 80 of the present invention has laser media 63a and 63b made of Ti doped spinel type MgAl₂O₄ fluorescent material and a laser medium 63c made of Mn doped spinel type MgAl₂O₄ fluorescent material disposed in series in the resonator made of the prism 61 and the semi-transparent mirror 62 whereby irradiating the laser media 63a, 63b and 63c laterally with excitation light 64 produces resonant lights 65 and causes laser oscillation lights 66a, 66b and 66c to be emitted.

For the excitation light 64, use may be made of the fourth harmonic (having a wavelength of 266 nm) of a Nd: YAG laser, the fourth harmonic (having a wavelength of 262 nm) of a Nd: YLF or the fourth harmonic (having a wavelength of 269 nm) of a Nd: YAP laser, as its source.

In the embodiments shown in Figs. 20(a) and (b), the use of a Ti doped spinel type MgAl₂O₄ fluorescent material for the laser medium allows blue or green colored laser oscillation light to be obtained by utilizing light emission having a peak at 490 nm of this fluorescent material. Also, the use of a Mn doped spinel type MgAl₂O₄ fluorescent material for the laser medium allows red colored laser oscillation light to be obtained by utilizing light emission having a peak at 650 nm of this fluorescent material. Also, the use of a V doped spinel type MgAl₂O₄ fluorescent material for the laser medium allows white colored laser oscillation light to be obtained by utilizing broad light emissions from 400 nm to 800 nm of this fluorescent material.

According to the embodiment shown in Fig. 20(c), blue and green colored laser oscillation light emissions can be obtained respectively from the two laser media of Ti doped spinel type MgAl₂O₄ fluorescent material 63a and 63b and red colored laser light emission from the laser medium of Mn doped spinel type MgAl₂O₄ fluorescent material 63c, concurrently; hence there result laser light emissions of the three primary colors.

Also, in another embodiment not shown in diagram, a laser medium of Ti doped spinel type MgAl₂O₄ fluorescent material and two laser media of Mn doped spinel type MgAl₂O₄ fluorescent material may be disposed in series in an external laser resonator and these three laser media may be side-pumped with the fourth harmonic (having a wavelength of 266 nm) of a Nd: YAG laser, the fourth harmonic (having a wavelength of 262 nm) of a Nd: YLF, or the fourth harmonic (having a wavelength of 269 nm) of a Nd: YAP laser, making it possible to produce blue or green emission from the laser medium of Ti doped spinel type MgAl₂O₄ fluorescent material, and green or blue and red emissions, respectively, from the two laser media of Mn doped spinel type MgAl₂O₄ fluorescent material, simultaneously, and thus to obtain a laser of the three primary colors.

Also, in another embodiment not shown in diagram, a first laser medium of Ti doped spinel type MgAl₂O₄ fluorescent material and a second laser medium of Mn doped spinel type MgAl₂O₄ fluorescent material may be disposed in series in an external laser resonator and these two laser media of fluorescent materials may be side-pumped with the fourth harmonic (having a wavelength of 266 nm) of a Nd: YAG laser, the fourth harmonic (having a wavelength of 262 nm) of a Nd: YLF, or the fourth harmonic (having a wavelength of 269 nm) of a Nd: YAP laser, making it possible to produce blue or green emission from the Ti doped spinel type MgAl₂O₄ fluorescent material, and green or blue and red emissions from the Mn doped spinel type MgAl₂O₄ fluorescent material, simultaneously, and thus to obtain a laser of the three primary colors.

Mention is next made of a specific example of the laser apparatus according to the present invention. In the makeup shown in Fig. 20(a), use was made of a Ti doped spinel type MgAl₂O₄ fluorescent material and a Mn doped spinel type MgAl₂O₄ fluorescent material for the laser medium and of a Nd: YAG (266 nm) for the excitation light source to produce laser oscillations. The prism was composed of fused quartz, the mirror had a reflectance of 98 %, the laser medium had a length of about 2 cm and the excitation light had an intensity of 10 MW/cm².

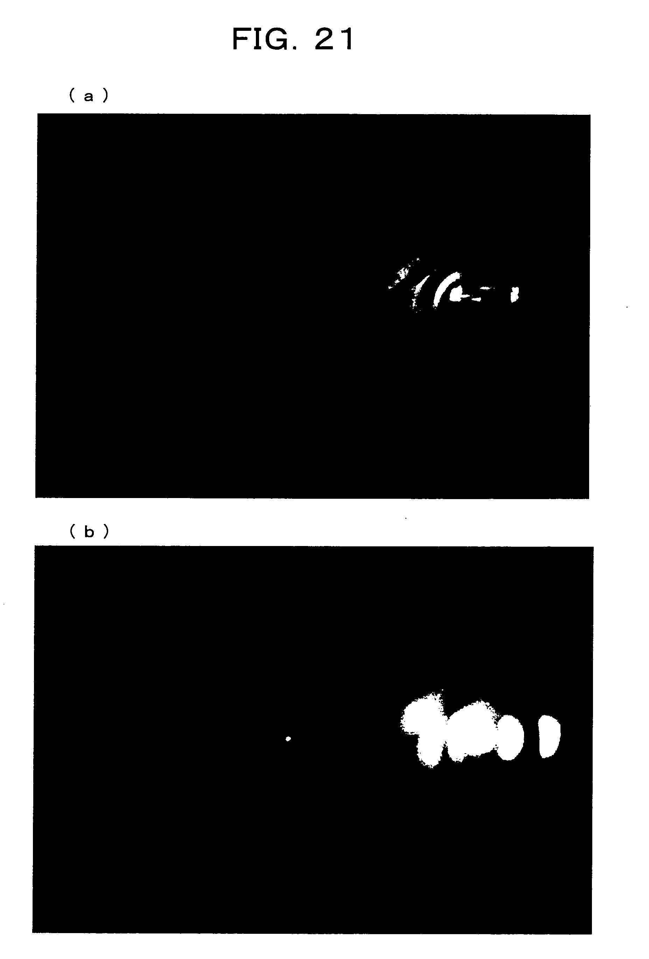

Fig. 21 is a photograph showing oscillations of such a Ti doped spinel type MgAl₂O₄ fluorescent material laser apparatus of the present invention, in which Fig. 21 (a) shows blue color laser oscillations obtained using a Ti doped spinel type MgAl₂O₄ fluorescent material as the laser medium and Fig. 21(b) is a near-field pattern of the blue color oscillations shown in Fig. 21(a).

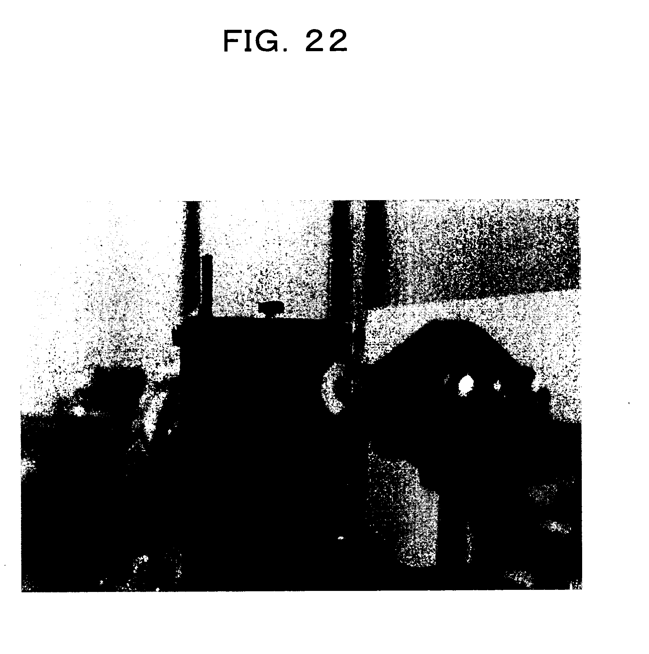

Fig. 22 shows orange (red) color laser oscillations of such a Mn doped spinel type MgAl₂O₄ fluorescent material laser apparatus of the present invention.

Each of these photographs was taken at a distance of about 1 m obliquely from a screen irradiated by laser light as seen in its center of the photographs. Due to high intensity of the laser light, the entire laboratory seems colored with the laser oscillation light.

### Industrial Applicability

High in crystallographic perfection of its matrix crystal and also high in its fluorescent emission efficiency, a transition metal doped spinel type MgAl₂O₄ fluorescent material according to the present invention can be used as a laser medium of a laser of external resonator type and can be used in a laser oscillation apparatus for emissions with various wavelengths in a visible light range. Also, when used as a laser medium in a light source of ultrashort light pulses, it can be used in an ultrashort light pulse laser apparatus having a wavelength center in a visible light region. Further, it is useful to use it as a fluorescent material for many kind of color displays as well.

## Claims

1. A transition metal doped spinel type MgAl₂O₄ fluorescent material, **characterized in that** it is made by single-crystallizing a source material rod in a selected gaseous atmosphere, wherein the source material rod is formed from a mixed raw material of an Al raw material and a Mg raw material so that the amount of Mg exceeds that of Al by a few percents in terms of molar ratio, added thereto together in an amount with a transition metal raw material.

2. A transition metal doped spinel type MgAl₂O₄ fluorescent material as set forth in claim 1, **characterized in that** said source material rod is formed by forming said mixed raw material under pressure and is single-crystallized by floating zone melting.

3. A transition metal doped spinel type MgAl₂O₄ fluorescent, material as set forth in claim 1, **characterized in that** said gaseous atmosphere is an oxidizing or inert gas.

4. A transition metal doped spinel type MgAl₂O₄ fluorescent material as set forth in claim 1, **characterized in that** said transition metal is Ti and said transition metal doped spinel type MgAl₂O₄ fluorescent material has a composition expressed by chemical formula MgAl₂₋ₓTiₓO₄ where 0.003≦ x≦ 0.01, and that this fluorescent material has no absorption except for its band edge absorption in a light wavelength range of 200 nm to 900 nm and it is capable of light emission having a peak at 490 nm by its band edge excitation.

5. A transition metal doped spinel type MgAl₂O₄ fluorescent material as set forth in claim 1, **characterized in that** said transition metal is Mn and said transition metal doped spinel type MgAl₂O₄ fluorescent material has a composition expressed by chemical formula Mg₁₋ₓMnₓAlO₄ where 0.003 ≦ x ≦ 0.01, and that this fluorescent material has its band edge absorption and absorption having an absorption peak at 450 nm which increases proportionally as the amount of Mn doped is increased in a light wavelength range of 200 nm to 900 nm and it is capable of light emission having a peak at 520 nm by excitation of 450 nm light and having a peak at 650 nm by its band edge excitation.

6. A transition metal doped spinel type MgAl₂O₄ fluorescent material as set forth in claim 1, **characterized in that** said transition metal is V and said transition metal doped spinel type MgAl₂O₄ fluorescent material has a composition expressed by chemical formula MgAl₂₋ₓVₓO₄ where 0.001≦ x≦ 0.01, and that this fluorescent material has no absorption peak except for its band edge absorption in a light wavelength range of 200 nm to 900 nm and it is capable of white color light emission over wavelengths of 450 nm to 750 nm by its band edge excitation.

7. A laser apparatus having a laser medium made of a transition metal doped spinel type MgAl₂O₄ fluorescent material as set forth in any one of claims 1 to 6.

8. A laser apparatus having a laser medium made of a transition metal doped spinel type MgAl₂O₄ fluorescent material as set forth in claim 7, **characterized in that** the laser medium is made of a fluorescent material as set forth in claim 4 and that said laser medium is side-pumped with a fourth harmonic of a Nd: YAG laser (having a wavelength of 266 nm), a fourth harmonic of a Nd: YLF (having a wavelength of 262 nm), or a fourth harmonic of a Nd: YAP laser (having a wavelength of 269 nm) and is caused to resonate with an external laser resonator to produce blue or green color laser light utilizing light emission having the peak at 490 nm of said fluorescent material.

9. A laser apparatus having a laser medium made of a transition metal doped spinel type MgAl₂O₄ fluorescent material as set forth in claim 7, **characterized in that** the laser medium is made of a fluorescent material as set forth in claim 5 and that said laser medium is side-pumped with a fourth harmonic of a Nd: YAG laser (having a wavelength of 266 nm), a fourth harmonic of a Nd: YLF (having a wavelength of 262 nm), or a fourth harmonic of a Nd: YAP laser (having a wavelength of 269 nm) and is caused to resonate with an external laser resonator to produce red color laser light utilizing light emission having the peak at 650 nm of said fluorescent material.

10. A laser apparatus having a laser medium made of a transition metal doped spinel type MgAl₂O₄ fluorescent material as set forth in claim 7, **characterized in that** two laser media made of a fluorescent material as set forth in claim 4 and a laser medium made of a fluorescent material as set forth in claim 5 are disposed in series in an external laser resonator and these three laser media are side-pumped with a fourth harmonic of a Nd: YAG laser (having a wavelength of 266 nm), a fourth harmonic of a Nd: YLF (having a wavelength of 262 nm), or a fourth harmonic of a Nd: YAP laser (having a wavelength of 269 nm) to produce blue and green color laser oscillations, respectively, from the first two laser media and red color laser oscillation from the third laser medium, simultaneously.

11. A laser apparatus having a laser medium made of a transition metal doped spinel type MgAl₂O₄ fluorescent material as set forth in claim 7, **characterized in that** a laser media made of a fluorescent material as set forth in claim 4 and two laser media made of a fluorescent material as set forth in claim 5 are disposed in series in an external laser resonator and these three laser media are side-pumped with a fourth harmonic of a Nd: YAG laser (having a wavelength of 266 nm), a fourth harmonic of a Nd: YLF (having a wavelength of 262 nm), or a fourth harmonic of a Nd: YAP laser (having a wavelength of 269 nm) to produce blue or green color laser oscillation from the first laser medium and blue or green and red color laser oscillations, respectively, from the second and third laser media, simultaneously.

12. A laser apparatus having a laser medium made of a transition metal doped spinel type MgAl₂O₄ fluorescent material as set forth in claim 7, **characterized in that** a first laser media made of a fluorescent material as set forth in claim 4 and a second laser medium made of a fluorescent material as set forth in claim 5 are disposed in series in an external laser resonator and these two laser media are side-pumped with a fourth harmonic of a Nd: YAG laser (having a wavelength of 266 nm), a fourth harmonic of a Nd: YLF (having a wavelength of 262 nm), or a fourth harmonic of a Nd: YAP laser (having a wavelength of 269 nm) to produce blue or green color laser oscillation from said first laser medium and blue or green and red color laser oscillations from said second laser medium, simultaneously.

13. A method of making a transition metal doped spinel type MgAl₂O₄ fluorescent material, **characterized in that** it comprises: preparing a mixed raw material of an Al raw material and a Mg raw material so that the amount of Mg exceeds that of Al by a few percents in terms of molar ratio, adding thereto together in an amount with a transition metal raw material, shaping the mixed raw material under pressure to form a source material rod, and single-crystallizing the source material rod in a selected gaseous atmosphere by floating zone melting.

14. A method of making a transition metal doped spinel type MgAl₂O₄ fluorescent material as set forth in claim 13, **characterized in that** said selected gaseous atmosphere is an oxidizing or inert gas.

15. A method of making a transition metal doped spinel type MgAl₂O₄ fluorescent material as set forth in claim 13, **characterized in that** said Al raw material is Al₂O₃, said Mg raw material is MgO, and said transition metal raw material is TiO₂ and that the raw material TiO₂ is added to the raw material Al₂O₃ at a proportion in a range of 0.003 to 0.01 in terms of molar ratio.

16. A method of making a transition metal doped spinel type MgAl₂O₄ fluorescent material as set forth in claim 13, **characterized in that** said Al raw material is Al₂O₃, said Mg raw material is MgO, and said transition metal raw material is MnO₂ and that the raw material MnO₂ is added to the raw material MgO at a proportion in a range of 0.003 to 0.01 in terms of molar ratio.

17. A method of making a transition metal doped spinel type MgAl₂O₄ fluorescent material as set forth in claim 13, **characterized in that** said Al raw material is Al₂O₃, said Mg raw material is MgO, and said transition metal raw material is a V metal raw material, and that the V metal raw material is added to the raw material Al₂O₃ at a proportion in a range of 0.001 to 0.01 in terms of molar ratio.

18. A method of making a transition metal doped spinel type MgAl₂O₄ fluorescent material, **characterized in that** it comprises: mixing together a source material Al₂O₃, a source material MgO, and a transition metal raw material to form a mixture thereof; shaping under pressure, and sintering the mixture to form a sintered body, and epitaxially growing on a single-crystal substrate a single-crystal thin film of transition metal doped spinel type MgAl₂O₄ fluorescent material by laser ablation using said sintered body as a target in an O₂ gas.
